# EUROPEAN PATENT APPLICATION

(11) **EP 4 539 103 A1**
(43) Date of publication of application: **16.04.2025**
(21) Application number: 23823780.4
(22) Date of filing: 06.06.2023
(51) Int. Cl.: H01L 21/301, B32B 7/023, B32B 7/027, B32B 7/06, B32B 27/00, C09J 7/29, C09J 7/38, H01L 21/304, H01L 21/50

(54) **ADHESIVE SHEET FOR PROVISIONAL FIXATION OF ELECTRONIC COMPONENT**

(30) Priority: 13.06.2022 JP 2022095262; 13.06.2022 JP 2022095264; 02.06.2023 JP 2023091813
(71) Applicant: Nitto Denko Corporation, Ibaraki-shi, Osaka 567-8680 (JP)
(72) Inventor: UENO, Shusaku, Ibaraki-shi, Osaka 567-8680 (JP); KATAOKA, Naoki, Ibaraki-shi, Osaka 567-8680 (JP); SHISHIDO, Yuichiro, Ibaraki-shi, Osaka 567-8680 (JP)
(74) Representative: Müller-Boré & Partner Patentanwälte PartG mbB
(86) International application number: PCT/JP2023/020977
(87) International publication number: WO 2023/243488

(57) **Abstract**

Provided is an adhesive/pressure-sensitive adhesive sheet for temporarily fixing an electronic part having a photothermal conversion function, the adhesive/pressure-sensitive adhesive sheet for temporarily fixing an electronic part having excellent heat resistance. The adhesive/pressure-sensitive adhesive sheet for temporarily fixing an electronic part according to an embodiment of the present invention includes a photothermal conversion layer. The adhesive/pressure-sensitive adhesive sheet for temporarily fixing an electronic part has a transmittance for light having a wavelength of 1,032 nm of 60% or less. The adhesive/pressure-sensitive adhesive sheet for temporarily fixing an electronic part has a transmittance for light having a wavelength of 355 nm of 60% or less. The photothermal conversion layer contains carbon black. The photothermal conversion layer has a 5% weight loss temperature after UV irradiation of 300°C or more.

## Description

### Technical Field

The present invention relates to an adhesive/pressure-sensitive adhesive sheet for temporarily fixing an electronic part.

### Background Art

In recent years, for improvements in characteristics of a semiconductor device, there has been a growing trend toward performing a high-temperature process by fixing a semiconductor chip or a resin substrate after sealing to a hard support substrate mainly in fields such as semiconductor packaging. For example, in, for example, a RDL formation process for forming a circuit on a semiconductor package sealed with a black resin, there has been investigated a method involving temporarily fixing a workpiece to an optically transparent substrate such as glass in a flat manner and separating the hard substrate after performing the RDL formation on the workpiece. In such usage, a liquid adhesive containing carbon black powder as a photothermal conversion material is widely used. In a technology involving using a photothermal conversion material, a photothermal conversion layer is formed on an optically transparent substrate through application of the photothermal conversion material thereon. Accordingly, a workpiece can be firmly fixed at the time of processing, and the workpiece and the optically transparent substrate can be easily separated from each other (subjected to laser debonding) by irradiation with laser light having a predetermined wavelength, and thermal decomposition of the photothermal conversion layer through absorption of the light and conversion of the light into heat at the time of peeling. However, as the liquid adhesive serving as the photothermal conversion material, a material having added thereto carbon black powder or a filler has been adopted in many cases. In such cases, a sedimentation phenomenon of a dispersion liquid occurs over time, and hence there has been a problem in that the management of the material is difficult at the time of its production. As a method of solving such problem, a technology of using, for example, a generally-used black printed base material in which a material containing carbon black is formed into a film to form a double-sided tape has been investigated, but there has been a problem in that heat resistance and chemical resistance characteristics of a black printed layer are poor, and hence the material cannot be applied to semiconductor applications.

### Citation List

### Patent Literature

[PTL 1] JP 4565804 B2
[PTL 2] JP 4405246 B2

### Summary of Invention

### Technical Problem

The present invention has been made in order to solve the above-mentioned problem, and an object of the present invention is to provide an adhesive/pressure-sensitive adhesive sheet for temporarily fixing an electronic part having a photothermal conversion function, the adhesive/pressure-sensitive adhesive sheet for temporarily fixing an electronic part having excellent heat resistance.

### Solution to Problem

[1] According to an embodiment of the present invention, there is provided an adhesive/pressure-sensitive adhesive sheet for temporarily fixing an electronic part, including a photothermal conversion layer, wherein the adhesive/pressure-sensitive adhesive sheet for temporarily fixing an electronic part has a transmittance for light having a wavelength of 1,032 nm of 60% or less, wherein the adhesive/pressure-sensitive adhesive sheet for temporarily fixing an electronic part has a transmittance for light having a wavelength of 355 nm of 60% or less, wherein the photothermal conversion layer contains carbon black, and wherein the photothermal conversion layer has a 5% weight loss temperature after UV irradiation of 300°C or more.
[2] In the adhesive/pressure-sensitive adhesive sheet for temporarily fixing an electronic part according to the above-mentioned item [1], the photothermal conversion layer may include a curable resin composition.
[3] In the adhesive/pressure-sensitive adhesive sheet for temporarily fixing an electronic part according to the above-mentioned item [2], the photothermal conversion layer may contain a photopolymerization initiator.
[4] In the adhesive/pressure-sensitive adhesive sheet for temporarily fixing an electronic part according to the above-mentioned item [3], the curable resin composition may contain a pentaerythritol-based polyfunctional (meth)acrylate.
[5] In the adhesive/pressure-sensitive adhesive sheet for temporarily fixing an electronic part according to the above-mentioned item [1], the photothermal conversion layer may contain a styrene-based thermoplastic elastomer.
[6] In the adhesive/pressure-sensitive adhesive sheet for temporarily fixing an electronic part according to any one of the above-mentioned items [1] to [5], the adhesive/pressure-sensitive adhesive sheet may further include a base material, and the photothermal conversion layer may be arranged on at least one side of the base material.

### Advantageous Effects of Invention

According to the present invention, the adhesive/pressure-sensitive adhesive sheet for temporarily fixing an electronic part that has a photothermal conversion function and has excellent heat resistance can be provided.

### Brief Description of Drawings

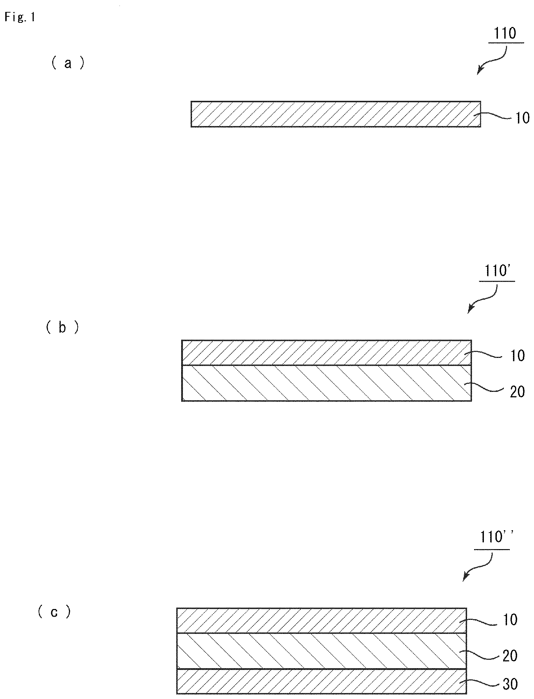

FIGS. **1** are each a schematic sectional view of an adhesive/pressure-sensitive adhesive sheet for temporarily fixing an electronic part according to one embodiment of the present invention.

### Description of Embodiments

### A. Outline of Adhesive/pressure-sensitive Adhesive Sheet for temporarily fixing Electronic Part

FIGS. **1** are each a schematic sectional view of an adhesive/pressure-sensitive adhesive sheet for temporarily fixing an electronic part according to one embodiment of the present invention. An adhesive/pressure-sensitive adhesive sheet **110** for temporarily fixing an electronic part includes a PHOTOTHERMAL conversion layer **10.** An adhesive/pressure-sensitive adhesive sheet **110'** for temporarily fixing an electronic part may further include a base material **20** as illustrated in FIG. **1(b)****.** In one embodiment, the photothermal conversion layer **10** is arranged on at least one side of the base material **20.** In one embodiment, an adhesive/pressure-sensitive adhesive sheet **110''** for temporarily fixing an electronic part further includes a pressure-sensitive adhesive layer **30.** For example, the photothermal conversion layer **10,** the base material **20,** and the pressure-sensitive adhesive layer **30** are arranged in the stated order. The base material **20** may be omitted. In addition, the adhesive/pressure-sensitive adhesive sheet for temporarily fixing an electronic part may include any appropriate other layer as required, though the layer is not shown. The term "adhesive/pressure-sensitive adhesive sheet" as used herein is a concept encompassing a pressure-sensitive adhesive sheet and an adhesive sheet. The adhesive/pressure-sensitive adhesive sheet for temporarily fixing an electronic part is hereinafter sometimes simply referred to as "adhesive/pressure-sensitive adhesive sheet."

The photothermal conversion layer is a layer that absorbs light having a predetermined wavelength and converts the light into heat. The photothermal conversion layer itself is decomposed or a layer adjacent to the photothermal conversion layer is thermally decomposed by the heat generation of the photothermal conversion layer. As a result, the adhesive/pressure-sensitive adhesive sheet for temporarily fixing an electronic part shows peelability. In one embodiment, the photothermal conversion layer has a pressure-sensitive adhesive property or an adhesive property before the absorption of the light having the predetermined wavelength. The shape of the surface of the photothermal conversion layer changes through the absorption of the light having the predetermined wavelength, to show peelability. In addition, any one layer for forming the adhesive/pressure-sensitive adhesive sheet is thermally decomposed by the heat generation of the photothermal conversion layer to generate a gas, and as a result, the shape of the surface of the adhesive/pressure-sensitive adhesive sheet may change to exhibit peelability. The term "thermal decomposition" as used herein means that a weight reduction of 5% or more may occur through heating to 250°C or more (preferably 300°C or more).

The photothermal conversion layer contains carbon black. In the photothermal conversion layer, when the light having the predetermined wavelength is absorbed by the carbon black, the above-mentioned photothermal conversion action is exhibited. The photothermal conversion layer containing the carbon black may be applied to the adhesive/pressure-sensitive adhesive sheet in a film shape, and hence is advantageous in that the management of the material becomes easier than that when a liquid photothermal conversion material is used. In addition, the photothermal conversion layer is also advantageous in that a configuration having excellent heat resistance and chemical resistance can be achieved.

The transmittance of the adhesive/pressure-sensitive adhesive sheet for light having a wavelength of 1,032 nm is 60% or less. When the transmittance falls within such range, an adhesive/pressure-sensitive adhesive sheet that preferably exhibits a photothermal conversion action can be obtained. The transmittance of the adhesive/pressure-sensitive adhesive sheet for light having a wavelength of 1,032 nm is preferably 55% or less, more preferably 50% or less, still more preferably 40% or less, particularly preferably 30% or less. When the transmittance falls within such ranges, an adhesive/pressure-sensitive adhesive sheet having excellent peelability by IR laser light can be obtained. In one embodiment, the transmittance of the adhesive/pressure-sensitive adhesive sheet for light having a wavelength of 1,032 nm is 10% or more. In another embodiment, the transmittance of the adhesive/pressure-sensitive adhesive sheet for light having a wavelength of 1,032 nm is from 0% to 5%, from 0% to 2%, or 0%.

The transmittance of the adhesive/pressure-sensitive adhesive sheet for light having a wavelength of 355 nm is 60% or less. When the transmittance falls within such range, an adhesive/pressure-sensitive adhesive sheet that preferably exhibits a photothermal conversion action can be obtained. The transmittance of the adhesive/pressure-sensitive adhesive sheet for light having a wavelength of 355 nm is preferably 50% or less, more preferably 45% or less, still more preferably 40% or less. When the transmittance falls within such ranges, an adhesive/pressure-sensitive adhesive sheet having excellent peelability by UV laser light can be obtained. In one embodiment, the transmittance of the adhesive/pressure-sensitive adhesive sheet for light having a wavelength of 355 nm is 10% or more. In another embodiment, the transmittance of the adhesive/pressure-sensitive adhesive sheet for light having a wavelength of 355 nm is from 0% to 5%, from 0% to 2%, or 0%.

According to the present invention, when the photothermal conversion layer containing the carbon black is formed into a configuration having a transmittance for light having a wavelength of 1,032 nm of 60% or less and a transmittance for light having a wavelength of 355 nm of 60% or less, an adhesive/pressure-sensitive adhesive sheet for temporarily fixing an electronic part, which can generate peelability by any one of an infrared ray and UV light, and has a wide range of selection of the light to be applied, can be obtained.

The 5% weight loss temperature of the photothermal conversion layer is 300°C or more after the photothermal conversion layer has been irradiated with light having a wavelength of 365 nm at an integrated light quantity of 1,380 mJ/cm². When the 5% weight loss temperature falls within such range, a photothermal conversion layer excellent in heat resistance can be obtained. The 5% weight loss temperature means a temperature at the time point when the weight of a sample to be evaluated at the time of an increase in temperature of the sample reduces by 5 wt% as compared to the dry weight of the sample before the temperature increase. The 5% weight loss temperature is measured with a differential thermal analyzer under the measurement conditions of a rate of temperature increase of 10°C/min and a flow rate of 25 ml/min under a nitrogen atmosphere. The dry weight of the sample means the weight except moisture in the sample. As used herein, the 5% weight loss temperature after the photothermal conversion layer has been irradiated with light having a wavelength of 365 nm at an integrated light quantity of 1,380 mJ/cm² is hereinafter sometimes simply referred to as "5% weight loss temperature after UV irradiation."

An initial (normal) pressure-sensitive adhesive strength of the adhesive/pressure-sensitive adhesive sheet at 23°C when the photothermal conversion layer is bonded to a PET is preferably from 0.2 N/20 mm to 10 N/20 mm, more preferably from 3 N/20 mm to 8 N/20 mm. When the initial pressure-sensitive adhesive strength falls within such ranges, an adhesive/pressure-sensitive adhesive sheet suitable for an application of temporary fixing without causing a positional shift or the like on a support can be obtained. The initial pressure-sensitive adhesive strength is a pressure-sensitive adhesive strength before the exhibition of peelability through absorption of the light. A pressure-sensitive adhesive strength is measured in conformity with JIS Z 0237:2000. Specifically, the measurement is performed by: reciprocating a 2-kilogram roller once to bond the photothermal conversion layer to a glass plate (arithmetic average surface roughness Ra: 10±8 nm); and then peeling the adhesive/pressure-sensitive adhesive sheet under the conditions of a peel angle of 180° and a peel rate (tensile rate) of 300 mm/min.

An initial (normal) pressure-sensitive adhesive strength of the adhesive/pressure-sensitive adhesive sheet at 23°C when the photothermal conversion layer is bonded to a glass plate is preferably from 0.20 N/20 mm to 10 N/20 mm, more preferably from 1 N/20 mm to 7 N/20 mm, still more preferably from 2 N/20 mm to 5 N/20 mm. When the initial pressure-sensitive adhesive strength falls within such ranges, an adhesive/pressure-sensitive adhesive sheet suitable for an application of temporary fixing without causing a positional shift or the like on a support can be obtained.

In one embodiment, a pressure-sensitive adhesive strength at 23°C after UV irradiation after the photothermal conversion layer has been bonded to the glass plate, and the resultant has been irradiated with light having a wavelength of 365 nm at an integrated light quantity of 1,380 mJ/cm² is preferably from 0.01 N/20 mm to 3 N/20 mm, more preferably from 0.04 N/20 mm to 2 N/20 mm. When the pressure-sensitive adhesive strength falls within such ranges, an adhesive/pressure-sensitive adhesive sheet having excellent peelability can be obtained. The UV irradiation may be performed, for example, from a glass plate side.

The thickness of the adhesive/pressure-sensitive adhesive sheet for temporarily fixing an electronic part is preferably from 10 µm to 500 µm, more preferably from 20 µm to 400 µm.

In one embodiment, the adhesive/pressure-sensitive adhesive sheet is used by: bonding one side (photothermal conversion layer side) to a support (e.g., carrier glass); and arranging an electronic part (e.g., a semiconductor part such as a semiconductor wafer) on the other side thereof. In the present invention, when the adhesive/pressure-sensitive adhesive sheet of the present invention is used, separation of the electronic part from the support can be easily performed by the above-mentioned action of the photothermal conversion layer. In addition, fixing and peeling of the electronic part may be performed by arranging the electronic part on the photothermal conversion layer side.

### B. Photothermal Conversion Layer

In one embodiment, the photothermal conversion layer is a layer that may be thermally decomposed by the application of heat to generate a gas. The heat to be applied may be caused by the heat generation of the photothermal conversion layer, or may be caused by the heat generation of a layer (e.g., base material) different from the photothermal conversion layer for forming the adhesive/pressure-sensitive adhesive sheet. Herein, it should be noted that the characteristics "after UV irradiation" may be defined, but whether the characteristics of the photothermal conversion layer are changed through UV irradiation is not specified with such definition. The photothermal conversion layer may be a layer having characteristics that are changed (e.g., cured) through UV irradiation, or may be a layer having characteristics that are not changed even by UV irradiation.

In one embodiment, the photothermal conversion layer is a layer capable of absorbing a near infrared ray. More specifically, the transmittance of the photothermal conversion layer for light having a wavelength of 1,032 nm is preferably 60% or less, more preferably 55% or less, still more preferably 50% or less, yet still more preferably 40% or less, particularly preferably 30% or less. When the transmittance falls within such ranges, a photothermal conversion layer that preferably absorbs IR laser light and easily generates heat can be formed. In one embodiment, the transmittance of the photothermal conversion layer for light having a wavelength of 1,032 nm is 5% or more.

In one embodiment, the photothermal conversion layer is a layer capable of absorbing UV light. In one embodiment, the transmittance of the photothermal conversion layer for light having a wavelength of 355 nm is preferably 60% or less, more preferably 50% or less, still more preferably 45% or less, yet still more preferably 40% or less. In one embodiment, the transmittance of the photothermal conversion layer for light having a wavelength of 355 nm is 1% or more.

The thickness of the photothermal conversion layer is preferably from 1 µm to 100 µm, more preferably from 2 µm to 50 µm, still more preferably from 3 µm to 30 µm, particularly preferably from 5 µm to 20 µm.

As described above, the 5% weight loss temperature of the photothermal conversion layer after UV irradiation is 300°C or more. The 5% weight loss temperature of the photothermal conversion layer after UV irradiation is preferably from 310°C to 400°C, more preferably from 320°C to 380°C, particularly preferably from 330°C to 370°C. When the 5% weight loss temperature after UV irradiation falls within such ranges, an adhesive/pressure-sensitive adhesive sheet excellent in heat resistance can be obtained. In addition, in general, a RDL formation process is performed at a temperature of 250°C or less, and hence, when the 5% weight loss temperature after UV irradiation falls within the above-mentioned ranges, an outgas from the photothermal conversion layer in the RDL formation process reduces to alleviate an influence on an electronic part, and hence a stable process can be achieved.

The modulus of elasticity of the photothermal conversion layer measured by a nanoindentation method after the photothermal conversion layer has been irradiated with light having a wavelength of 365 nm at an integrated light quantity of 1,380 mJ/cm² (also referred to as "modulus of elasticity after UV irradiation") is preferably 1 MPa or more, more preferably from 50 MPa to 5 GPa, still more preferably from 200 MPa to 3 GPa. When the modulus of elasticity falls within such ranges, a change in shape of the photothermal conversion layer preferably occurs at the time of the irradiation with laser light, and hence excellent peelability can be exhibited. In one embodiment, the modulus of elasticity of the photothermal conversion layer after UV irradiation measured by the nanoindentation method is set to 200 MPa or more (preferably 300 MPa or more, more preferably 500 MPa or more). When the modulus of elasticity falls within such ranges, a photothermal conversion layer having particularly excellent heat resistance and chemical resistance can be formed. The modulus of elasticity measured by the nanoindentation method refers to a modulus of elasticity determined from an applied load-indentation depth curve, which is obtained by continuously measuring a load to be applied to an indenter and the indentation depth thereof when the indenter is indented into the sample over a time period from the start of loading to the end of unloading. The modulus of elasticity measured by the nanoindentation method is obtained by: perpendicularly pressing a Berkovich (triangular pyramid-shaped) probe made of diamond against a layer surface to be measured; and subjecting the thus obtained displacement-load hysteresis curve to numerical processing with software (TriboScan) included with a measurement apparatus. As used herein, the term "modulus of elasticity measured by a nanoindentation method" refers to a modulus of elasticity measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 100 nm. The modulus of elasticity of the photothermal conversion layer after UV irradiation may be adjusted on the basis of, for example, the kind of a material contained in the layer, the structure of a base polymer for forming the material, and the kind and amount of an additive added to the layer.

The tensile modulus of elasticity of the photothermal conversion layer after the photothermal conversion layer has been irradiated with light having a wavelength of 365 nm at an integrated light quantity of 1,380 mJ/cm² is preferably 0.1 MPa or more, more preferably from 5 MPa to 5 GPa, still more preferably from 20 MPa to 3 GPa. When the tensile modulus of elasticity falls within such ranges, a change in shape of the photothermal conversion layer preferably occurs at the time of the irradiation with laser light, and hence excellent peelability can be exhibited. In one embodiment, the tensile modulus of elasticity of the photothermal conversion layer after the photothermal conversion layer has been irradiated with light having a wavelength of 365 nm at an integrated light quantity of 1,380 mJ/cm² is set to 20 MPa or more (preferably 30 MPa or more, more preferably 50 MPa or more). A measurement method for the tensile modulus of elasticity is described later.

As described above, the photothermal conversion layer contains the carbon black. The photothermal conversion layer is typically formed of any appropriate resin, and may be formed by incorporating the carbon black into the resin.

The content of the carbon black is preferably from 1 part by weight to 50 parts by weight, more preferably from 3 parts by weight to 40 parts by weight, still more preferably from 5 parts by weight to 30 parts by weight with respect to 100 parts by weight of the resin. When the content falls within such ranges, a photothermal conversion layer, which can preferably exhibit a photothermal conversion function, and has excellent mechanical strength, can be formed.

Any appropriate resin may be used as the resin for forming the photothermal conversion layer. Examples of the resin for forming the photothermal conversion layer include an acrylic resin, an epoxy-based resin, a polyester-based resin, a polystyrene-based resin, a polyimide-based resin, and a polyurethane-based resin. Of those, an acrylic resin is preferred.

The photothermal conversion layer may be formed of a curable resin composition (curable pressure-sensitive adhesive), or may be formed of a pressure-sensitive adhesive having pressure sensitivity. Examples of the pressure-sensitive adhesive having pressure sensitivity include an acrylic pressure-sensitive adhesive, a silicone-based pressure-sensitive adhesive, an epoxy-based pressure-sensitive adhesive, a styrene-based thermoplastic elastomer, and an ester-based pressure-sensitive adhesive. Of those, a styrene-based thermoplastic elastomer is preferably used.

The photothermal conversion layer preferably includes a curable (e.g., active energy ray-curable or thermosetting) resin composition, more preferably includes a cured product of an active energy ray-curable resin composition, and still more preferably includes a cured product of an acrylic active energy ray-curable resin composition. According to the photothermal conversion layer formed of the cured product of the curable resin composition, there is an advantage in that the photothermal conversion layer is excellent in heat resistance. In one embodiment, the photothermal conversion layer formed as the cured product of the curable resin composition contains a polymerization initiator. The polymerization initiator is, for example, a photopolymerization initiator or a thermal polymerization initiator. The photothermal conversion layer including the curable resin composition preferably contains the photopolymerization initiator. The near infrared ray absorber may be incorporated in the curable resin composition. In one embodiment, the curable resin composition contains a pentaerythritol-based polyfunctional (meth)acrylate. When the pentaerythritol-based polyfunctional (meth)acrylate is used, a photothermal conversion layer excellent in heat resistance can be formed.

In one embodiment, an active energy ray-curable resin composition (A1), which contains a base polymer serving as a parent agent (alternatively, a monomer or an oligomer for forming the base polymer) and an active energy ray-reactive compound (monomer or oligomer), is used as the active energy ray-curable resin composition. In another embodiment, an active energy ray-curable resin composition (A2) containing an active energy ray-reactive polymer as a base polymer is used. In one embodiment, the base polymer has a functional group that may be cleaved by a photopolymerization initiator. An example of the functional group is a functional group having a carbon-carbon double bond. Examples of the active energy ray include a gamma ray, UV light, visible light, an infrared ray (heat ray), a radio wave, an alpha ray, a beta ray, an electron beam, a plasma flow, an ionizing ray, and a particle beam. Of those, UV light is preferred.

Examples of the base polymer to be used in the resin composition (A1) include: rubber-based polymers, such as a natural rubber, a polyisobutylene rubber, a styrene-butadiene rubber, a styrene-isoprene-styrene block copolymer rubber, a reclaimed rubber, a butyl rubber, a polyisobutylene rubber, and a nitrile rubber (NBR); silicone-based polymers; and acrylic polymers. Those polymers may be used alone or in combination thereof. Of those, an acrylic polymer is preferred.

Examples of the acrylic polymer include: homopolymers or copolymers of (meth)acrylic acid esters, such as a (meth)acrylic acid alkyl ester, a (meth)acrylic acid cycloalkyl ester, and a (meth)acrylic acid aryl ester; and copolymers of the (meth)acrylic acid esters and other copolymerizable monomers. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl

(meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

Examples of the other copolymerizable monomer include functional group-containing monomers, such as a carboxy group-containing monomer, an acid anhydride monomer, a hydroxy group-containing monomer, a glycidyl group-containing monomer, a sulfonic acid group-containing monomer, a phosphoric acid group-containing monomer, an acrylamide, and acrylonitrile. Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate. Examples of the glycidyl group-containing monomer include glycidyl (meth)acrylate and methylglycidyl (meth)acrylate. Examples of the sulfonic acid group-containing monomer include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. An example of the phosphoric acid group-containing monomer is 2-hydroxyethylacryloyl phosphate. An example of the acrylamide is N-acryloylmorpholine. Those monomers may be used alone or in combination thereof. The content of a constituent unit derived from the copolymerizable monomer is preferably 60 parts by weight or less, more preferably 40 parts by weight or less with respect to 100 parts by weight of the base polymer (acrylic polymer).

In one embodiment, as a monomer for forming the acrylic polymer, there is used an acrylic monomer that has a glass transition temperature of 40°C or more when turned into a homopolymer. That is, the acrylic polymer contains a constituent unit derived from the acrylic monomer that has a glass transition temperature of 40°C or more when turned into a homopolymer. Examples of such acrylic monomer include methyl methacrylate, glycidyl methacrylate, isobutyl methacrylate, acrylonitrile, methacrylonitrile, isopropyl acrylamide, acryloylmorpholine, and isobornyl acrylate. Of those, methyl methacrylate is preferred. When an acrylic polymer containing a constituent unit derived from such monomer is used, stickiness resulting from a product decomposed by irradiation with laser light can be prevented. The content of the constituent unit derived from the acrylic monomer that has a glass transition temperature of 40°C or more when turned into a homopolymer is preferably from 30 parts by weight to 80 parts by weight, more preferably from 40 parts by weight to 75 parts by weight with respect to 100 parts by weight of the base polymer (acrylic polymer). When the content falls within such ranges, the effect becomes significant.

The acrylic polymer may contain a constituent unit derived from a polyfunctional monomer. When the polyfunctional monomer is used, a photothermal conversion layer excellent in heat resistance can be formed. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate (i.e., polyglycidyl (meth)acrylate), polyester (meth)acrylate, and urethane (meth)acrylate. Those monomers may be used alone or in combination thereof. When the acrylic polymer includes the constituent unit derived from the polyfunctional monomer, the content of the constituent unit derived from the polyfunctional monomer is preferably 30 parts by weight or more, more preferably 40 parts by weight or more with respect to 100 parts by weight of the base polymer (acrylic polymer). The upper limit of the content of the constituent unit derived from the polyfunctional monomer is preferably 400 parts by weight or less, more preferably 300 parts by weight or less with respect to 100 parts by weight of the base polymer (acrylic polymer).

The weight-average molecular weight of the acrylic polymer is preferably from 10,000 to 1,500,000, more preferably from 20,000 to 1,000,000. The weight-average molecular weight may be measured by GPC (solvent: THF).

The active energy ray-reactive compound that may be used in the resin composition (A1) is, for example, a photoreactive monomer or oligomer having a functional group having a polymerizable carbon-carbon multiple bond, such as an acryloyl group, a methacryloyl group, a vinyl group, an allyl group, or an acetylene group. Specific examples of the photoreactive monomer include: esterified products of (meth)acrylic acid and polyhydric alcohols, such as trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, 1,4-butanediol di(meth)acrylate, 1,6-hexanediol di(meth)acrylate, and polyethylene glycol di(meth)acrylate; polyfunctional urethane (meth)acrylates; epoxy (meth)acrylates; and oligoester (meth)acrylates. In addition, a monomer, such as methacryloisocyanate, 2-methacryloyloxyethyl isocyanate (2-isocyanatoethyl methacrylate), or m-isopropenyl-α,α-dimethylbenzyl isocyanate, may be used. Specific examples of the photoreactive oligomer include dimers to pentamers of the above-mentioned monomers. The molecular weight of the photoreactive oligomer is preferably from 100 to 3,000.

In one embodiment, the active energy ray-curable resin composition (A1) contains a pentaerythritol-based polyfunctional (meth)acrylate as the active energy ray-reactive compound. The pentaerythritol-based polyfunctional (meth)acrylate may be obtained by esterifying part or whole of the hydroxy groups of pentaerythritol or a polymerized product thereof with a (meth)acrylate. When the pentaerythritol-based polyfunctional (meth)acrylate is used as the active energy ray-reactive compound, a photothermal conversion layer excellent in heat resistance can be formed.

In addition, a monomer, such as epoxidized butadiene, glycidyl methacrylate, acrylamide, or a vinylsiloxane, or an oligomer including the monomer may be used as the active energy ray-reactive compound.

The content of the active energy ray-reactive compound in the resin composition (A1) is preferably from 0.1 part by weight to 500 parts by weight, more preferably from 5 parts by weight to 300 parts by weight, still more preferably from 40 parts by weight to 200 parts by weight with respect to 100 parts by weight of the base polymer.

The active energy ray-reactive polymer (base polymer) in the resin composition (A2) is, for example, a polymer having a functional group having a carbon-carbon multiple bond, such as an acryloyl group, a methacryloyl group, a vinyl group, an allyl group, or an acetylene group. Specific examples of the active energy ray-reactive polymer include: polymers including polyfunctional (meth)acrylates (e.g., polymers each including a constituent unit derived from a polyfunctional monomer); photocationically polymerizable polymers; cinnamoyl group-containing polymers such as polyvinyl cinnamate; diazotized amino novolac resins; and polyacrylamide.

In one embodiment, there is used an active energy ray-reactive polymer formed by introducing an active energy ray-polymerizable carbon-carbon multiple bond into a side chain of the acrylic polymer, a main chain thereof, and/or a terminal of the main chain. An approach to introducing a radiation-polymerizable carbon-carbon double bond into the acrylic polymer is, for example, a method including: copolymerizing raw material monomers including a monomer having a predetermined functional group (first functional group) to provide the acrylic polymer; and then subjecting a compound having a predetermined functional group (second functional group) that can react with the first functional group to be bonded thereto and the radiation-polymerizable carbon-carbon double bond to a condensation reaction or an addition reaction with the acrylic polymer while maintaining the radiation polymerizability of the carbon-carbon double bond.

Examples of the combination of the first functional group and the second functional group include: a carboxy group and an epoxy group; an epoxy group and a carboxy group; a carboxy group and an aziridyl group; an aziridyl group and a carboxy group; a hydroxy group and an isocyanate group; and an isocyanate group and a hydroxy group. Of those combinations, the combination of a hydroxy group and an isocyanate group or the combination of an isocyanate group and a hydroxy group is preferred from the viewpoint of the ease with which a reaction between the groups is tracked. In addition, technical difficulty in producing a polymer having an isocyanate group having high reactivity is high, and hence a case in which the first functional group of the acrylic polymer side is a hydroxy group and the second functional group is an isocyanate group is more preferred from the viewpoint of the ease with which the acrylic polymer is produced or obtained. In this case, examples of an isocyanate compound having both of a radiation-polymerizable carbon-carbon double bond and an isocyanate group serving as the second functional group include methacryloyl isocyanate, 2-methacryloyloxyethyl isocyanate, and m-isopropenyl-α,α-dimethylbenzyl isocyanate. In addition, a polymer containing a constituent unit derived from the above-mentioned hydroxy group-containing monomer is preferred as the acrylic polymer having the first functional group, and a polymer containing a constituent unit derived from an ether-based compound, such as 2-hydroxyethyl vinyl ether, 4-hydroxybutyl vinyl ether, or diethylene glycol monovinyl ether, is also preferred.

The resin composition (A2) may further contain the active energy ray-reactive compound (monomer or oligomer).

In one embodiment, the active energy ray-curable resin composition contains a polymerization initiator. As the polymerization initiator, for example, a photopolymerization initiator or a thermal polymerization initiator may be used. Of those, a photopolymerization initiator is preferred.

Any appropriate initiator may be used as the photopolymerization initiator. Examples of the photopolymerization initiator include: α-ketol-based compounds, such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether-based compounds, such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; photoactive oxime-based compounds such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphinoxides; and acylphosphonates. The usage amount of the photopolymerization initiator may be set to any appropriate amount.

In one embodiment, the active energy ray-curable resin composition may contain a photosensitizer.

The active energy ray-curable resin composition preferably contains a cross-linking agent. Examples of the cross-linking agent include an isocyanate-based cross-linking agent, an epoxy-based cross-linking agent, an oxazoline-based cross-linking agent, an aziridine-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, and an amine-based cross-linking agent.

The content of the cross-linking agent is preferably from 0.01 part by weight to 20 parts by weight with respect to 100 parts by weight of the base polymer of the resin composition.

In one embodiment, an epoxy-based cross-linking agent is preferably used. When the epoxy-based cross-linking agent is used, a photothermal conversion layer having a high 5% weight loss temperature after UV irradiation can be formed. Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name: "TETRAD-C"), 1,6-hexanediol diglycidyl ether (manufactured by Kyoeisha Chemical Co., Ltd., product name: "Epolight 1600"), neopentyl glycol diglycidyl ether (manufactured by Kyoeisha Chemical Co., Ltd., product name: "Epolight 1500NP"), ethylene glycol diglycidyl ether (manufactured by Kyoeisha Chemical Co., Ltd., product name: "Epolight 40E"), propylene glycol diglycidyl ether (manufactured by Kyoeisha Chemical Co., Ltd., product name: "Epolight 70P"), polyethylene glycol diglycidyl ether (manufactured by NOF Corporation, product name: "EPIOL E-400"), polypropylene glycol diglycidyl ether (manufactured by NOF Corporation, product name: "EPIOL P-200"), sorbitol polyglycidyl ether (manufactured by Nagase ChemteX Corporation, product name: "Denacol EX-611"), glycerol polyglycidyl ether (manufactured by Nagase ChemteX Corporation, product name: "Denacol EX-314"), pentaerythritol polyglycidyl ether, polyglycerol polyglycidyl ether (manufactured by Nagase ChemteX Corporation, product name: "Denacol EX-512"), sorbitan polyglycidyl ether, trimethylolpropane polyglycidyl ether, adipic acid diglycidyl ester, o-phthalic acid diglycidyl ester, triglycidyl-tris(2-hydroxyethyl)isocyanurate, resorcin diglycidyl ether, bisphenol-S-diglycidyl ether, and an epoxy-based resin having two or more epoxy groups in a molecule thereof. The content of the epoxy-based cross-linking agent may be set to any appropriate amount in accordance with desired characteristics, and is typically from 0.01 part by weight to 10 parts by weight, more preferably from 0.05 part by weight to 7 parts by weight with respect to 100 parts by weight of the base polymer.

In one embodiment, an isocyanate-based cross-linking agent is preferably used. Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name: "CORONATE L"), a trimethylolpropane/hexamethylene diisocyanate trimer adduct (manufactured by Nippon Polyurethane Industry Co., Ltd., product name: "CORONATE HL"), and an isocyanurate form of hexamethylene diisocyanate (manufactured by Nippon Polyurethane Industry Co., Ltd., product name: "CORONATE HX") . Of those, a cross-linking agent having 3 or more isocyanate groups is preferably used. The content of the isocyanate-based cross-linking agent may be set to any appropriate amount in accordance with desired characteristics, and is typically from 0.1 part by weight to 20 parts by weight, more preferably from 0.5 part by weight to 10 parts by weight with respect to 100 parts by weight of the base polymer.

The active energy ray-curable resin composition may further contain any appropriate additive as required. Examples of the additive include an active energy ray polymerization accelerator, a radical scavenger, a tackifier, a plasticizer (e.g., a trimellitate-based plasticizer or a pyromellitate-based plasticizer), a pigment, a dye, a filler, an age resistor, a conductive material, an antistatic agent, a UV absorber, a light stabilizer, a peeling modifier, a softener, a surfactant, a flame retardant, and an antioxidant.

### C. Base Material

The base material may include any appropriate resin. Examples of the resin include: polyolefin-based resins, such as a polyethylene-based resin, a polypropylene-based resin, a polybutene-based resin, and a polymethyl pentene-based resin; a polyurethane-based resin; a polyester-based resin; a polyimide-based resin; a polyether ketone-based resin; a polystyrene-based resin; a polyvinyl chloride-based resin; a polyvinylidene chloride-based resin; a fluorine-based resin; a silicone-based resin; a cellulose-based resin; and an ionomer resin.

In one embodiment, the base material includes a polyimide-based resin, a polyester-based resin, or a polyetheretherketone-based resin. Of those, a polyimide-based resin is preferred. Those resins each have UV absorbability, and when the resin is used, the range of selection of the kind of laser light is enlarged at the time of a peeling operation.

The thickness of the base material is preferably from 2 µm to 300 µm, more preferably from 2 µm to 100 µm, still more preferably from 2 µm to 50 µm.

In one embodiment, the transmittance of the base material for light having a wavelength of 1,032 nm is from 60% to 95%, preferably from 70% to 90%.

In one embodiment, the transmittance of the base material for light having a wavelength of 355 nm is preferably 50% or less, more preferably from 0% to 20%.

The tensile modulus of elasticity at 200°C of the base material is preferably from 5 MPa to 2 GPa, more preferably from 10 MPa to 1.8 GPa, still more preferably from 500 MPa to 1.8 GPa, particularly preferably from 1 GPa to 1.5 GPa. When the tensile modulus of elasticity falls within such ranges, a gas generated by thermal decomposition of the photothermal conversion layer through irradiation with laser light is preferably barriered by the base material, and hence peelability resulting from a change in shape of the surface of the photothermal conversion layer is preferably exhibited. The tensile modulus of elasticity may be measured with a dynamic viscoelasticity-measuring apparatus. A specific measurement method is described later.

The 5% weight loss temperature of the base material after UV irradiation is preferably 300°C or more, more preferably from 350°C to 650°C, still more preferably from 380°C to 600°C, particularly preferably from 400°C to 590°C. When the 5% weight loss temperature after UV irradiation falls within such ranges, an adhesive/pressure-sensitive adhesive sheet excellent in heat resistance can be obtained. In addition, in general, a RDL formation process is performed at a temperature of 250°C or less, and hence, when the 5% weight loss temperature after UV irradiation falls within the above-mentioned ranges, an outgas from the base material in the RDL formation process reduces to alleviate an influence on an electronic part, and hence a stable process can be achieved.

### D. Pressure-sensitive Adhesive Layer

The pressure-sensitive adhesive layer contains any appropriate pressure-sensitive adhesive. For example, the pressure-sensitive adhesive layer contains a pressure-sensitive adhesive having pressure sensitivity or a curable pressure-sensitive adhesive. The above-mentioned active energy ray-curable resin composition may be used as the curable pressure-sensitive adhesive.

Examples of the pressure-sensitive adhesive include an acrylic pressure-sensitive adhesive, a silicone-based pressure-sensitive adhesive, an epoxy-based pressure-sensitive adhesive, a styrene-based thermoplastic elastomer, and an ester-based pressure-sensitive adhesive. In one embodiment, an acrylic pressure-sensitive adhesive is used. Now, an example of the acrylic pressure-sensitive adhesive is described.

### (Base Polymer)

The acrylic pressure-sensitive adhesive is, for example, an acrylic pressure-sensitive adhesive obtained by using an acrylic polymer (homopolymer or copolymer), which uses one kind or two or more kinds of (meth)acrylic acid alkyl esters as monomer components, as a base polymer. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used. The content of the constituent unit of the (meth) acrylic acid alkyl ester in the acrylic polymer is preferably from 70 parts by weight to 100 parts by weight, more preferably from 75 parts by weight to 99.9 parts by weight, still more preferably from 80 parts by weight to 99.9 parts by weight with respect to 100 parts by weight of the acrylic polymer.

The acrylic polymer may contain a constituent unit derived from any other monomer copolymerizable with the (meth)acrylic acid alkyl ester as required for the purpose of modification of cohesive strength, heat resistance, or cross-linkability, an improvement in dimensional stability of the pressure-sensitive adhesive layer, or the like. Examples of such monomer include the following monomers:
carboxy group-containing monomers including: ethylenically unsaturated monocarboxylic acids, such as acrylic acid (AA), methacrylic acid (MAA), and crotonic acid; and ethylenically unsaturated dicarboxylic acids, such as maleic acid, itaconic acid, and citraconic acid, and anhydrides thereof (such as maleic anhydride and itaconic anhydride);
hydroxy group-containing monomers including: hydroxyalkyl (meth)acrylates, such as 2-hydroxyethyl (meth)acrylate, 2-hydroxypropyl (meth)acrylate, 3-hydroxypropyl (meth)acrylate, and 2-hydroxybutyl (meth)acrylate; unsaturated alcohols, such as vinyl alcohol and allyl alcohol; and ether-based compounds, such as 2-hydroxyethyl vinyl ether, 4-hydroxybutyl vinyl ether, and diethylene glycol monovinyl ether;
amino group-containing monomers including aminoethyl (meth)acrylate, N,N-dimethylaminoethyl (meth)acrylate, and t-butylaminoethyl (meth)acrylate;
epoxy group-containing monomers including glycidyl (meth)acrylate, methylglycidyl (meth)acrylate, and allyl glycidyl ether;
cyano group-containing monomers including acrylonitrile and methacrylonitrile;
keto group-containing monomers including diacetone (meth)acrylamide, diacetone (meth)acrylate, vinyl methyl ketone, vinyl ethyl ketone, allyl acetoacetate, and vinyl acetoacetate;
monomers each having a nitrogen atom-containing ring including N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and N-(meth)acryloylmorpholine;
alkoxysilyl group-containing monomers including 3-(meth)acryloxypropyltrimethoxysilane, 3-(meth)acryloxypropyltriethoxysilane, 3-(meth)acryloxypropylmethyldimethoxysilane, and 3-(meth)acryloxypropylmethyldiethoxysilane; and
isocyanate group-containing monomers including (meth)acryloyl isocyanate, 2-(meth)acryloyloxyethyl isocyanate, and m-isopropenyl-α,α-dimethylbenzyl isocyanate.

Those monomers may be used alone or in combination thereof.

The weight-average molecular weight of the acrylic polymer is preferably from 600,000 to 1,600,000, more preferably from 800,000 to 1,500,000. When the weight-average molecular weight falls within such ranges, there can be formed a pressure-sensitive adhesive layer, which has excellent heat resistance and excellent dimensional stability under high temperature, and is suppressed in occurrence of outgassing by heating. The weight-average molecular weight may be measured by GPC (solvent: THF) .

### (Additive)

The acrylic pressure-sensitive adhesive may contain any appropriate additive as required. Examples of the additive include a cross-linking agent, a cross-linking catalyst, a tackifier, a plasticizer, a pigment, a dye, a filler, an age resistor, a conductive material, an antistatic agent, a UV absorber, a light stabilizer, a peeling modifier, a softener, a surfactant, a flame retardant, and an antioxidant.

Examples of the cross-linking agent include an isocyanate-based cross-linking agent, an epoxy-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, an oxazoline-based cross-linking agent, an aziridine-based cross-linking agent, and an amine-based cross-linking agent. Of those, an epoxy-based cross-linking agent or an isocyanate-based cross-linking agent is preferred.

In one embodiment, a heat-resistant pressure-sensitive adhesive is used as the pressure-sensitive adhesive in the pressure-sensitive adhesive layer. Herein, the heat-resistant pressure-sensitive adhesive means a pressure-sensitive adhesive having a predetermined pressure-sensitive adhesive strength under an environment at 260°C. The heat-resistant pressure-sensitive adhesive may be preferably used without causing an adhesive residue under an environment at 260°C. The heat-resistant pressure-sensitive adhesive preferably contains, for example, an acrylic resin or a silicone-based resin as the base polymer.

The thickness of the pressure-sensitive adhesive layer is preferably from 5 µm to 100 µm, more preferably from 10 µm to 50 µm.

The transmittance of the pressure-sensitive adhesive layer for light having a wavelength of 1,032 nm is preferably 75% or more, more preferably 85% or more, still more preferably 90% or more. The upper limit of the transmittance for light having a wavelength of 1,032 nm is, for example, 97% (preferably 98%).

The transmittance of the pressure-sensitive adhesive layer for light having a wavelength of 355 nm is preferably 75% or more, more preferably 85% or more, still more preferably 90% or more. The upper limit of the transmittance for light having a wavelength of 355 nm is, for example, 97% (preferably 98%).

### E. Method of producing Adhesive/pressure-sensitive Adhesive Sheet for temporarily fixing Electronic Part

The adhesive/pressure-sensitive adhesive sheet for temporarily fixing an electronic part may be produced by any appropriate method. The method of producing the adhesive/pressure-sensitive adhesive sheet for temporarily fixing an electronic part includes, for example, a step (A) of preparing a composition for forming a photothermal conversion layer, a step (B) of applying the composition for forming a photothermal conversion layer to a support, and a step (C) of curing an application layer of the composition for forming a photothermal conversion layer. The support may be a base material for forming the adhesive/pressure-sensitive adhesive sheet.

The composition for forming a photothermal conversion layer contains carbon black. In one embodiment, the composition for forming a photothermal conversion layer may be the above-mentioned curable resin composition (preferably the above-mentioned active energy ray-curable resin composition) containing the carbon black.

Any appropriate method may be adopted as a method of applying the composition for forming a photothermal conversion layer. Examples of the method of applying the composition for forming a photothermal conversion layer include bar coater coating, air knife coating, gravure coating, gravure reverse coating, reverse roll coating, lip coating, die coating, dip coating, offset printing, flexographic printing, and screen printing.

When the composition for forming a photothermal conversion layer contains an active energy ray-reactive compound, in the step (C), the application layer of the composition for forming a photothermal conversion layer is irradiated with an active energy ray such as UV light. Conditions for the irradiation may be set to any appropriate conditions in accordance with the composition of the composition for forming a photothermal conversion layer.

When the composition for forming a photothermal conversion layer has a thermosetting property, heating treatment is performed in the step (C). Conditions for the heating may be set to any appropriate conditions in accordance with the composition of the composition for forming a photothermal conversion layer.

### Examples

Now, the present invention is specifically described by way of Examples. However, the present invention is by no means limited to these Examples. Evaluation methods in Examples are as described below. In addition, the terms "part(s)" and "%" in Examples are by weight unless otherwise stated.

### [Evaluation]

### (1) Tensile Modulus of Elasticity

A modulus of elasticity was measured with a dynamic viscoelasticity-measuring apparatus (manufactured by TA Instruments, product name: "RSA-3") under the following conditions. A tensile modulus of elasticity at 200°C was measured for a base material. A modulus of elasticity at 25°C after UV light (specific wavelength: 365 nm, integrated light quantity: 1,380 mJ/cm²) of a high-pressure mercury lamp was applied once was measured for a photothermal conversion layer.
Measurement frequency: 1 Hz
Strain: 0.05%
Chuck-to-chuck distance: 20 mm
Sample width: 10 mm
Rate of temperature increase from 0°C to 250°C of 5°C/min

### (2) Modulus of Elasticity of Photothermal Conversion Layer after UV Irradiation measured by Nanoindentation Method

The photothermal conversion layer after UV light (specific wavelength: 365 nm, integrated light quantity: 1,380 mJ/cm²) of a high-pressure mercury lamp was applied once from a photothermal conversion layer side to each of the adhesive/pressure-sensitive adhesive sheets obtained in Examples and Comparative Examples was used as an evaluation sample.

The modulus of elasticity of the sample was measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 100 nm.

### (3) 5% Weight Loss Temperatures of Base Material and Photothermal Conversion Layer after UV Irradiation

The base material and the photothermal conversion layer after UV light (specific wavelength: 365 nm, integrated light quantity: 1,380 mJ/cm²) of a high-pressure mercury lamp was applied once from a photothermal conversion layer side to each of the adhesive/pressure-sensitive adhesive sheets obtained in Examples and Comparative Examples were each used as an evaluation sample.

The temperature at which the weight of a predetermined sample reduced by 5% as compared to the dry weight of the sample before the temperature increase was measured with a differential thermal analyzer (manufactured by TA Instruments, product name: "Discovery TGA") at a rate of temperature increase of 10°C/min and a flow rate of 25 ml/min under a N₂ atmosphere. The dry weight of the sample means the weight except moisture in the sample.

Specifically, about 0.01 g of the evaluation sample was set in the analyzer. An influence of moisture incorporated therein was removed by increasing the temperature from 20°C to 110°C once at the above-mentioned rate of temperature increase and then decreasing the temperature from 110°C to 20°C at a rate of temperature decrease of 10°C/min, and the dry weight was thus obtained. The weight loss of the evaluation sample was measured while its temperature was increased again from 20°C to 500°C at the above-mentioned rate of temperature increase. The temperature at which the weight loss became 5% was sampled from the obtained data.

### (4) Light Transmittances of Base Material, Photothermal Conversion Layer, and Adhesive/Pressure-sensitive Adhesive Sheet

The evaluation sample was set in a spectrophotometer (product name: "UV-VIS SPECTROPHOTOMETER SolidSpec 3700", manufactured by Shimadzu Corporation), and its light transmittance in the wavelength region of from 300 nm to 2,500 nm was measured while incident light was adapted to vertically enter each sample. Transmittances at wavelengths of 355 nm and 1,032 nm in the resultant transmission spectrum were sampled.

### (5) Pressure-sensitive Adhesive Strength on Pressure-sensitive Adhesive Layer Side

The photothermal conversion layer side of the adhesive/pressure-sensitive adhesive sheet was bonded and fixed to a stainless-steel plate, and the pressure-sensitive adhesive layer was bonded to a polyethylene terephthalate film (manufactured by Toray Industries, Inc., product name: "Lumirror S10", thickness: 25 µm). A pressure-sensitive adhesive strength to PET #25 on the pressure-sensitive adhesive layer side was measured by a method in conformity with JIS Z 0237:2000 (bonding conditions: one reciprocation of a 2-kilogram roller, tensile rate: 300 mm/min, peel angle: 180°, measurement temperature: 23°C).

### (6) Initial (Normal) Pressure-sensitive Adhesive Strength to Glass (Photothermal Conversion Layer Side)

The photothermal conversion layer side of the adhesive/pressure-sensitive adhesive sheet was bonded to glass, and an initial pressure-sensitive adhesive strength to glass of the adhesive/pressure-sensitive adhesive sheet on the photothermal conversion layer side was measured by a method in conformity with JIS Z 0237:2000 (bonding conditions: one reciprocation of a 2-kilogram roller, tensile rate: 300 mm/min, peel angle: 180°, measurement temperature: 23°C). A non-tin surface of a glass slide (manufactured by Matsunami Glass Ind., Ltd., product number: S200423 (Water Edge Grinding, 65 mm×165 mm×1.3 mmT)) was used as each of the above-mentioned glass and glass in the following evaluation (7). The non-tin surface was recognized as a surface in which coloring was not exhibited through the UV irradiation with a UV lamp.

### (7) Pressure-sensitive Adhesive Strength to Glass after UV Irradiation (Photothermal Conversion Layer Side)

The photothermal conversion layer side of the adhesive/pressure-sensitive adhesive sheet was bonded to glass, and UV light (specific wavelength: 365 nm, integrated light quantity: 1,380 mJ/cm²) of a high-pressure mercury lamp was applied from the glass side to the entire surface of the photothermal conversion layer side through use of a UV irradiation apparatus (manufactured by Nitto Seiki Co., Ltd., product name: "UM-810"). After that, a pressure-sensitive adhesive strength to glass after UV irradiation was measured by a method in conformity with JIS Z 0237:2000 (bonding conditions: one reciprocation of a 2-kilogram roller, tensile rate: 300 mm/min, peel angle: 180°, measurement temperature: 23°C).

### (8) Laser Debonding Property Evaluation

### ·Laser Debonding Property Evaluation by IR laser

The pressure-sensitive adhesive layer (thickness: 10 µm) of each of the adhesive/pressure-sensitive adhesive sheets was bonded to thin glass (cover glass manufactured by Matsunami Glass Ind., Ltd., Rectangular No. 1, product name: "C050701") having a width of 50 mm, a length of 70 mm, and a thickness of 0.12 mmt, the thin glass simulating a workpiece such as a semiconductor wafer, with a hand roller, and the adhesive/pressure-sensitive adhesive sheet was cut in accordance with the size of the thin glass. After that, the photothermal conversion layer was laminated on a support (thick glass (large glass slide manufactured by Matsunami Glass Ind., Ltd., Standard Large White Edge Grinding No. 2, product name: "S9112") having a width of 52 mm, a length of 76 mm, and a thickness of 1.0 mmt, the thick glass simulating an optically transparent support substrate) with a hand roller. After that, the laminate was loaded in an autoclave, and was defoamed by warming (at 40°C and 5 kgf for 10 minutes) so that air bubbles trapped in the laminate were removed. Further, UV light (specific wavelength: 365 nm, integrated light quantity: 1,380 mJ/cm²) of a high-pressure mercury lamp was applied from the thick glass side to the entire surface of the photothermal conversion layer through use of a UV irradiation apparatus (manufactured by Nitto Seiki Co., Ltd., product name: "UM-810"). Thus, a laminate sample was produced.

Laser light was applied from the support side to the produced laminate sample to perform a laser debonding property evaluation. Specifically, a pulse scan was performed with laser light having a wavelength of 1,032 nm and a beam diameter of about 200 µmϕ at an output of 5.6 W and a frequency of 25 kHz so that pitch intervals were about 60 µm longitudinally and laterally. After the application of the laser light to the laminate sample, the debonding property was evaluated by the following criteria.

The evaluation of a laser debonding property was performed as described below. In the debonding work of the thin glass and the thick glass, the level at which the debonding was able to be easily performed when one site of the outer peripheral portion of the laminate sample was lifted with a cutter blade was evaluated as a success in the debonding workability (o), the level at which the debonding was able to be performed only when the entire outer peripheral portion was lifted with a cutter blade was evaluated as (Δ), and the level at which the debonding was unable to be performed even when a cutter blade was inserted in the outer peripheral portion or cracking of the thin glass (workpiece) occurred was evaluated as a failure (×).

### ·Laser Debonding Property Evaluation by UV Laser

A laminate sample was obtained in the same manner as in the section "Laser Debonding Property Evaluation by IR Laser."

Laser light was applied from the support side to the produced laminate sample to perform a laser debonding property evaluation. Specifically, a pulse scan was performed with laser light having a wavelength of 355 nm and a beam diameter of about 100 µmϕ at an output of 3.0 W and a frequency of 25 kHz so that pitch intervals were about 60 µm longitudinally and laterally.

### (9) Chemical Resistance

The photothermal conversion layer side of the adhesive/pressure-sensitive adhesive sheet was bonded to a support (thick glass (large glass slide manufactured by Matsunami Glass Ind., Ltd., Standard Large White Edge Grinding No. 2, product name: "S9112") having a width of 52 mm, a length of 76 mm, and a thickness of 1.0 mmt, the thick glass simulating an optically transparent support substrate) with a hand roller. UV light (specific wavelength: 365 nm, integrated light quantity: 1,380 mJ/cm²) of a high-pressure mercury lamp was applied from the glass side to the entire surface of the photothermal conversion layer side through use of a UV irradiation apparatus (manufactured by Nitto Seiki Co., Ltd., product name: "UM-810"). The bonded sample was immersed in each of three polar solvents including N-methyl-2-pyrrolidone (manufactured by Kishida Chemical Co., Ltd.), propylene glycol monomethyl ether acetate (manufactured by Tokyo Chemical Industry Co., Ltd.), and dimethyl sulfoxide (manufactured by Tokyo Chemical Industry Co., Ltd.). After that, the resultants were left at 25°C for 15 minutes, and then the samples were taken out. The various polar solvents were wiped off, and appearance of each of the samples was observed. The level at which no change was observed in the appearance after the immersion was evaluated as chemical resistance success (∘), and the level at which a change, such as decolorizing, swelling, or peeling, was observed in the photothermal conversion layer after the immersion was evaluated as chemical resistance failure (×).

### [Production Example 1] Composition A for forming Photothermal Conversion Layer

30 Parts by weight of 2-ethylhexyl acrylate, 70 parts by weight of methyl acrylate, 10 parts by weight of acrylic acid, and 0.2 part by weight of benzoyl peroxide serving as a polymerization initiator were added into ethyl acetate, and then the mixture was heated to 70°C to provide a solution of an acrylic polymer (polymer A) in ethyl acetate.

The solution of the polymer A in ethyl acetate (polymer A: 100 parts by weight), 200 parts by weight of an active energy ray-curable oligomer (manufactured by the Nippon Synthetic Chemical Industry Co., Ltd., product name: "SHIKOH UV-1700B"), 0.3 part by weight of an epoxy-based cross-linking agent (manufactured by Mitsubishi Gas Chemical Company, Inc., product name: "TETRAD-C"), 1.5 parts by weight of a polymerization initiator (manufactured by BASF SE, product name: "Omnirad 127D"), and 30 parts by weight of carbon black (manufactured by Dainichiseika Color & Chemicals Mfg. Co., Ltd., product name: "DYMIC SZ 7740 Black") were mixed to prepare a composition A for forming a photothermal conversion layer. The composition of the composition A for forming a photothermal conversion layer is shown in Table 1.

**Table 1**

| Composition for forming photothermal conversion layer | | | Composition A for forming photothermal conversion layer | Composition B for forming photothermal conversion layer | Composition C for forming photothermal conversion layer | Composition D for forming photothermal conversion layer | Composition E for forming photothermal conversion layer |
|---|---|---|---|---|---|---|---|
| Composition | Material | | Acrylic | Acrylic | Acrylic | Acrylic | Acrylic |
| | Kind of polymer | | Polymer A | Polymer A | Polymer A | Polymer A | Polymer B |
| | UV oligomer | | UV-curable urethane acrylate | UV-curable urethane acrylate | UV-curable urethane acrylate | UV-curable urethane acrylate | UV-curable urethane acrylate |
| | | Product name | UV-1700B | UV-1700B | UV-1700B | UV-1700B | UV-1700B |
| | | Number of parts | 200 | 100 | 100 | 100 | 30 |
| | Kind of cross-linking agent | | Epoxy-based | Epoxy-based | Epoxy-based | Epoxy-based | Epoxy-based |
| | | Product name | TETRAD-C | TETRAD-C | TETRAD-C | TETRAD-C | TETRAD-C |
| | | Number of parts | 0.3 | 0.3 | 0.3 | 0.3 | 1 |
| | Kind of photopolymerization initiator | | α-Hydroxyketone-based | α-Hydroxyketone-based | α-Hydroxyketone-based | α-Hydroxyketone-based | α-Hydroxyketone-based |
| | | Product name | Omnirad 127D | Omnirad 127D | Omnirad 127D | Omnirad 127D | Omnirad 127D |
| | | Number of parts | 1.5 | 1.5 | 1.5 | 1.5 | 1.5 |
| | Photothermal conversion material | | Carbon black | Carbon black | Carbon black | Carbon black | Carbon black |
| | | Product name | SZ 7740 | SZ 7740 | SZ 7740 | SZ 7740 | SZ 7740 |
| | | Number of parts | 30 | 10 | 20 | 40 | 15 |
| Configuration | Thickness [µm] | | 10 | 10 | 10 | 10 | 10 |
| Characteristics of photothermal conversion layer | 5% weight loss temperature after UV irradiation [°C] | | 347.8 | 342.4 | 341 | 339.5 | 330.2 |
| | Transmittance at 355 nm [%] | | 35.60 | 53.10 | 30.70 | 9.60 | 32.90 |
| | Transmittance at 1,032 nm [%] | | 40.10 | 57.60 | 35.40 | 14.00 | 38.20 |
| | Tensile modulus of elasticity E' [MPa] | | 2,818.4 | 2,238.7 | 2,238.7 | 2,238.7 | 39.8 |
| | Nanoindenter modulus of elasticity [MPa] | | 18,213.4 | 14,674.7 | 14,674.7 | 14,674.7 | 334.7 |

| Composition for forming photothermal conversion layer | | | Composition F for forming photothermal conversion layer | Composition G for forming photothermal conversion layer | Composition H for forming photothermal conversion layer | Composition "i" for forming resin layer |
|---|---|---|---|---|---|---|
| Composition | Material | | SEBS-based | Acrylic | Acrylic | Acrylic |
| | Kind of polymer | | Polymer C | Polymer B | Polymer B | Polymer A (HAMO) |
| | UV oligomer | | - | - | - | UV oligomer UV-curable urethane acrylate |
| | | Product name | - | - | - | UV-1700B |
| | | Number of parts | | | | 100 |
| | Kind of cross-linking agent | | Epoxy-based | Epoxy-based | Epoxy-based | Epoxy-based |
| | | Product name | TETRAD-C | TETRAD-C | TETRAD-C | TETRAD-C |
| | | Number of parts | 3 | 5 | 1 | 0.3 |
| | Kind of photopolymerization initiator | | - | - | - | α-Hydroxyketone-based |
| | | Product name | - | - | - | Omnirad 127D |
| | | Number of parts | | | | 1.5 |
| | Photothermal conversion material | | Carbon black | Carbon black | Carbon black | - |
| | | Product name | SZ 7740 | SZ 7740 | SZ 7740 | - |
| | | Number of parts | 5 | 5 | 5 | |
| Configuration | Thickness [µm] | | 10 | 10 | 10 | 10 |
| Characteristics of photothermal conversion layer | 5% weight loss temperature after UV irradiation [°C] | | 410.4 | 358.5 | 342.7 | 351.2 |
| | Transmittance at 355 nm [%] | | 55.90 | 53.70 | 54.00 | 89.20 |
| | Transmittance at 1,032 nm [%] | | 59.50 | 58.30 | 58.90 | 94.10 |
| | Tensile modulus of elasticity E' [MPa] | | 7.8 | 2.0 | 0.4 | 2,238.7 |
| | Nanoindenter modulus of elasticity [MPa] | | 72.2 | 20.6 | 4.4 | 14, 674.7 |

### [Production Examples 2 to 4] Compositions B to D for forming Photothermal Conversion Layers

Compositions B to D for forming photothermal conversion layers were prepared in the same manner as in Production Example 1 except that the blending amounts of the active energy ray-curable oligomer, the epoxy-based cross-linking agent, the polymerization initiator, and the carbon black were set as shown in Table 1.

### [Production Example 5] Composition E for forming Photothermal Conversion Layer

50 Parts by weight of butyl acrylate, 50 parts by weight of ethyl acrylate, 5 parts by weight of acrylic acid, 0.1 part by weight of 2-hydroxyethyl acrylate, 0.3 part by weight of trimethylolpropane triacrylate (TMPTA), and 0.1 part by weight of benzoyl peroxide serving as a polymerization initiator were added into toluene, and then the mixture was heated to 70°C to provide a solution of an acrylic polymer (polymer B) in toluene.

The solution of the polymer B in ethyl acetate (polymer B: 100 parts by weight), 30 parts by weight of an active energy ray-curable oligomer (manufactured by the Nippon Synthetic Chemical Industry Co., Ltd., product name: "SHIKOH UV-1700B"), 1 part by weight of an epoxy-based cross-linking agent (manufactured by Mitsubishi Gas Chemical Company, Inc., product name: "TETRAD-C"), 1.5 parts by weight of a polymerization initiator (manufactured by BASF SE, product name: "Omnirad 127D"), and 15 parts by weight of carbon black (manufactured by Dainichiseika Color & Chemicals Mfg. Co., Ltd., product name: "DYMIC SZ 7740 Black") were mixed to prepare a composition E for forming a photothermal conversion layer. The composition of the composition E for forming a photothermal conversion layer is shown in Table 1.

### [Production Example 6] Composition F for forming Photothermal Conversion Layer

100 Parts by weight of a maleic acid-modified styrene-ethylene-butylene-styrene block copolymer (SEBS: styrene moiety/ethylene-butylene moiety (weight ratio)=30/70, acid value: 10 (mg-CH₃ONa/g), manufactured by Asahi Kasei Chemicals Corporation, product name: "Tuftec M1913"), 3 parts by weight of an epoxy-based cross-linking agent (manufactured by Mitsubishi Gas Chemical Company, Inc., product name: "TETRAD-C"), 5 parts by weight of carbon black (manufactured by Dainichiseika Color & Chemicals Mfg. Co., Ltd., product name: "DYMIC SZ 7740 black"), and toluene serving as a solvent were mixed to prepare a composition F for forming a photothermal conversion layer. The composition of the composition F for forming a photothermal conversion layer is shown in Table 1.

### [Production Example 7] Composition G for forming Photothermal Conversion Layer

The solution of the polymer B in ethyl acetate (polymer B: 100 parts by weight), 5 parts by weight of an epoxy-based cross-linking agent (manufactured by Mitsubishi Gas Chemical Company, Inc., product name: "TETRAD-C"), and 5 parts by weight of carbon black (manufactured by Dainichiseika Color & Chemicals Mfg. Co., Ltd., product name: "DYMIC SZ 7740 Black") were mixed to prepare a composition G for forming a photothermal conversion layer. The composition of the composition G for forming a photothermal conversion layer is shown in Table 1.

### [Production Example 8] Composition H for forming Photothermal Conversion Layer

The solution of the polymer B in ethyl acetate (polymer B: 100 parts by weight), 1 part by weight of an epoxy-based cross-linking agent (manufactured by Mitsubishi Gas Chemical Company, Inc., product name: "TETRAD-C"), and 5 parts by weight of carbon black (manufactured by Dainichiseika Color & Chemicals Mfg. Co., Ltd., product name: "DYMIC SZ 7740 Black") were mixed to prepare a composition H for forming a photothermal conversion layer. The composition of the composition H for forming a photothermal conversion layer is shown in Table 1.

### [Production Example 9] (Composition "i" for forming Resin Layer)

A composition "i" for forming a resin layer was prepared in the same manner as in Production Example 2 except that the carbon black was not added.

### [Production Example 10] Preparation of Pressure-sensitive Adhesive A

95 Parts by weight of 2-ethylhexyl acrylate, 5 parts by weight of acrylic acid, and 0.15 part by weight of benzoyl peroxide serving as a polymerization initiator were added into ethyl acetate, and then the mixture was heated to 70°C to provide a solution of an acrylic polymer (polymer C) in ethyl acetate.

The solution of the polymer C in ethyl acetate (polymer C: 100 parts by weight) and 2 parts by weight of an epoxy-based cross-linking agent (manufactured by Mitsubishi Gas Chemical Company, Inc., product name: "TETRAD-C") were mixed to prepare a pressure-sensitive adhesive A.

### [Example 1]

The composition A for forming a photothermal conversion layer obtained in Production Example 1 was applied to a polyethylene terephthalate film with a silicone release agent-treated surface (thickness: 75 µm) so as to have a thickness of 10 µm after solvent volatilization (drying), and was then dried to form a photothermal conversion layer on the polyethylene terephthalate film. The resultant was bonded to a polyethylene terephthalate film with a silicone release agent-treated surface (manufactured by Toray Industries, Inc., product name: "Cerapeel", thickness: 38 µm) through lamination between rolls. Thus, an adhesive/pressure-sensitive adhesive sheet (photothermal conversion layer) sandwiched between the polyethylene terephthalate films with silicone release agent-treated surfaces was obtained. The resultant adhesive/pressure-sensitive adhesive sheet was subjected to the above-mentioned evaluations. The results are shown in Table 3.

### [Example 2]

The pressure-sensitive adhesive A obtained in Production Example 10 was applied to one side of a polyimide film (manufactured by Du Pont-Toray Co., Ltd., product name: "Kapton 100H", thickness: 25 µm) so as to have a thickness of 10 µm after solvent volatilization (drying), and was then dried to form a pressure-sensitive adhesive layer on the polyimide film. The resultant was bonded to a polyethylene terephthalate film with a silicone release agent-treated surface (manufactured by Toray Industries, Inc., product name: "Cerapeel", thickness: 38 µm) through lamination between rolls. Thus, a laminate (pressure-sensitive adhesive layer/base material (polyimide film)) was obtained. The characteristics of the base material used are shown in Table **2.**

The composition A for forming a photothermal conversion layer obtained in Production Example 1 was applied to the surface of the base material on the opposite side to the pressure-sensitive adhesive layer so as to have a thickness of 10 µm after solvent volatilization (drying), and was then dried to form a photothermal conversion layer on the polyimide film. The resultant was bonded to a polyethylene terephthalate film with a silicone release agent-treated surface (manufactured by Toray Industries, Inc., product name: "Cerapeel", thickness: 38 µm) through lamination between rolls. Thus, an adhesive/pressure-sensitive adhesive sheet (pressure-sensitive adhesive layer/base material/photothermal conversion layer) was obtained. The resultant adhesive/pressure-sensitive adhesive sheet was subjected to the above-mentioned evaluations. The results are shown in Table 3.

**Table 2**

| | Examples 1 to 5, 7, and 8, and Comparative Example 1 | Example 6 and Comparative Example 2 | Comparative Example 3 | Comparative Example 4 |
|---|---|---|---|---|
| Material | PI (polyimide) | PET | Black printed PET (1) | Black printed PET (2) |
| Thickness [µm] | 25 | 38 | 25 | 28 |
| Tensile modulus of elasticity E' of base material at 200°C [MPa] | 1,585 | 316 | 316 | 316 |
| 5% weight loss temperature after UV irradiation [°C] | 589.1 | 390.4 | Base material: 390.375 | Base material: 390.375 |
| | | | Photothermal conversion layer: 298.9 | Photothermal conversion layer: 240.6 |
| Transmittance at 355 nm [%] | 0.00 | 83.21 | 0.69 | 0.00 |
| Transmittance at 1,032 nm [%] | 87.39 | 90.65 | 43.66 | 2.40 |

### [Examples 3 to 5 and 7 to 10, and Comparative Example 1]

Adhesive/pressure-sensitive adhesive sheets were each obtained in the same manner as in Example 2 except that the composition for forming a photothermal conversion layer or the composition for forming a resin layer shown in Table 3 was used instead of the composition A for forming a photothermal conversion layer. The resultant adhesive/pressure-sensitive adhesive sheets were subjected to the above-mentioned evaluations. The results are shown in Table 3.

### [Example 6]

An adhesive/pressure-sensitive adhesive sheet was obtained in the same manner as in Example 2 except that a PET film (manufactured by Toray Industries, Inc., product name: "Lumirror S27", thickness: 38 µm) was used instead of the polyimide film (manufactured by Du Pont-Toray Co., Ltd., product name: "Kapton 100H", thickness: 25 µm). The resultant adhesive/pressure-sensitive adhesive sheet was subjected to the above-mentioned evaluations. The results are shown in Table 3.

### [Comparative Example 2]

An adhesive/pressure-sensitive adhesive sheet was obtained in the same manner as in Comparative Example 1 except that a PET film (manufactured by Toray Industries, Inc., product name: "Lumirror S27", thickness: 38 µm) was used instead of the polyimide film (manufactured by Du Pont-Toray Co., Ltd., product name: "Kapton 100H", thickness: 25 µm). The resultant adhesive/pressure-sensitive adhesive sheet was subjected to the above-mentioned evaluations. The results are shown in Table 3.

### [Comparative Example 3]

100 Parts by weight of a black printing ink "NB300" (manufactured by Dainichiseika Color & Chemicals Mfg. Co., Ltd.) with carbon black and 5 parts by weight of an isocyanate-based curing agent (manufactured by Dainichiseika Color & Chemicals Mfg. Co., Ltd., product name: "Lamic B Hardener") were mixed to prepare a composition C3 for forming a photothermal conversion layer. The "NB300" contained a polyurethane-based vinyl acetate-vinyl chloride copolymer serving as a binder resin, and an intensity peak that was considered to be derived from urethane was observed by IR.

The composition C3 for forming a photothermal conversion layer was applied to one side of a polyethylene terephthalate film (manufactured by Toray Industries, Inc., product name: "Lumirror S105", thickness: 25 µm) with a gravure coater so that its thickness after solvent volatilization (drying) became 0.2 µm. After that, the composition was dried to provide a laminate C3 (photothermal conversion layer/base material (polyethylene terephthalate film)).

The pressure-sensitive adhesive A obtained in Production Example 10 was applied to the base material side of the laminate C3 so as to have a thickness of 10 µm after solvent volatilization (drying), and was then dried to form a pressure-sensitive adhesive layer on the polyethylene terephthalate film. The resultant was bonded to a polyethylene terephthalate film with a silicone release agent-treated surface (manufactured by Toray Industries, Inc., product name: "Cerapeel", thickness: 38 µm) through lamination between rolls. Thus, a laminate (pressure-sensitive adhesive layer/base material (polyethylene terephthalate film) /photothermal conversion layer) was obtained.

The composition i for forming a resin layer obtained in Production Example 9 was applied to the surface of the laminate on the opposite side to the pressure-sensitive adhesive layer so as to have a thickness of 10 µm after solvent volatilization (drying), and was then dried to form a resin layer on the polyethylene terephthalate film. The resultant was bonded to a polyethylene terephthalate film with a silicone release agent-treated surface (manufactured by Toray Industries, Inc., product name: "Cerapeel", thickness: 38 µm) through lamination between rolls. Thus, an adhesive/pressure-sensitive adhesive sheet (pressure-sensitive adhesive layer/base material/photothermal conversion layer/resin layer) was obtained. The resultant adhesive/pressure-sensitive adhesive sheet was subjected to the above-mentioned evaluations. The results are shown in Table 3.

### [Comparative Example 4]

100 Parts by weight of a black printing ink "CVL-PR" (manufactured by DIC Corporation) with carbon black and 4 parts by weight of an isocyanate-based curing agent (manufactured by DIC Corporation, product name: "CVL Hardener No. 10") were mixed to prepare a composition C4 for forming a photothermal conversion layer. The "CVL-PR" contained a polyurethane-based vinyl acetate-vinyl chloride copolymer serving as a binder resin, and an intensity peak that was considered to be derived from urethane was observed by IR.

The composition C4 for forming a photothermal conversion layer was applied to one side of a polyethylene terephthalate film (manufactured by Toray Industries, Inc., product name: "Lumirror S105", thickness: 25 µm) with a gravure coater so that its thickness after solvent volatilization (drying) became 3 µm. After that, the composition was dried to provide a laminate C4 (photothermal conversion layer/base material (polyethylene terephthalate film)).

An adhesive/pressure-sensitive adhesive sheet was obtained in the same manner as in Comparative Example 3 except that the laminate C4 was used instead of the laminate C3. The resultant adhesive/pressure-sensitive adhesive sheet was subjected to the above-mentioned evaluations. The results are shown in Table 3.

**Table 3**

| Item | | Example 1 | Example 2 | Example 3 | Example 4 | Example 5 |
|---|---|---|---|---|---|---|
| Configuration | Pressure-sensitive adhesive layer | - | Pressure-sensitive adhesive A | Pressure-sensitive adhesive A | Pressure-sensitive adhesive A | Pressure-sensitive adhesive A |
| | Base material | - | Polyimide film | Polyimide film | Polyimide film | Polyimide film |
| | Composition for forming photothermal conversion layer | A | A | B | C | D |
| | Thickness of adhesive/pressure-sensitive adhesive sheet [µm] | 10 | 45 | 45 | 45 | 45 |
| Pressure-sensitive adhesive characteristic of pressure-sensitive adhesive layer | Normal pressure-sensitive adhesive strength to PET #25 [N/20 mm] | 0.82 | 0.82 | 0.82 | 0.82 | 0.82 |
| Pressure-sensitive adhesive characteristic of photothermal conversion layer | Normal pressure-sensitive adhesive strength to glass [N/20 mm] | 3.86 | 2.98 | 4.13 | 3.67 | 2.83 |
| | Pressure-sensitive adhesive strength to glass after UV irradiation (1,380 mJ/cm²) [N/20 mm] | 0.06 | 0.05 | 0.09 | 0.09 | 0.08 |
| Optical characteristics | Transmittance at 355 nm [%] | 35.60 | 0.00 | 0.00 | 0.00 | 0.00 |
| | Transmittance at 1,032 nm [%] | 40.10 | 39.10 | 55.90 | 34.10 | 12.90 |
| <Debonding property by IR laser light (wavelength: 1,032 nm)> | Debondability | ○ | ○ | ○ | ○ | ○ |
| | Site to be debonded | Interface between photothermal conversion layer and glass | Interface between photothermal conversion layer and glass | Interface between photothermal conversion layer and glass | Interface between photothermal conversion layer and glass | Interface between photothermal conversion layer and glass |
| <Debonding property by UV laser light (wavelength: 355 nm) > | Debondability | ○ | ○ | ○ | ○ | ○ |
| | Site to be debonded | Interface between photothermal conversion layer and glass | Interface between photothermal conversion layer and glass | Interface between photothermal conversion layer and glass | Interface between photothermal conversion layer and glass | Interface between photothermal conversion layer and glass |
| <Chemical resistance of photothermal conversion layer> ~After UV irradiation (1,380 mJ/cm²)~ | Tensile modulus of elasticity E' of photothermal conversion layer [MPa] | 2,818.4 | 2,818.4 | 2,238.7 | 2,238.7 | 2,238.7 |
| | Nanoindenter modulus of elasticity Er of photothermal conversion layer [MPa] | 18,213 | 18,213 | 14,675 | 14, 675 | 14,675 |
| | Appearance after being bonded to glass and immersed into NMP, and being left at 25°C for 15 min | ○ | ○ | ○ | ○ | ○ |
| <Heat resistance of photothermal conversion layer> | 5% weight loss temperature [°C] | 347.8 | 347.8 | 342.4 | 341.0 | 339.5 |

| Item | | Example 6 | Example 7 | Example 8 | Example 9 | Example 10 |
|---|---|---|---|---|---|---|
| Configuration | Pressure-sensitive adhesive layer | Pressure-sensitive adhesive A | Pressure-sensitive adhesive A | Pressure-sensitive adhesive A | Pressure-sensitive adhesive A | Pressure-sensitive adhesive A |
| | Base material | PET film | Polyimide film | Polyimide film | Polyimide film | Polyimide film |
| | Composition for forming photothermal conversion layer | A | E | F | G | H |
| | Thickness of adhesive/pressure-sensitive adhesive sheet [µm] | 58 | 45 | 45 | 45 | 45 |
| Pressure-sensitive adhesive characteristic of pressure-sensitive adhesive layer | Normal pressure-sensitive adhesive strength to PET #25 [N/20 mm] | 0.82 | 0.82 | 0.82 | 0.82 | 0.82 |
| Pressure-sensitive adhesive characteristic of photothermal conversion layer | Normal pressure-sensitive adhesive strength to glass [N/20 mm] | 2.43 | 3.42 | 1.03 | 0.28 | 3.79 |
| | Pressure-sensitive adhesive strength to glass after UV irradiation (1,380 mJ/cm²) [N/20 mm] | 0.04 | 0.1 | - | - | - |
| Optical characteristics | Transmittance at 355 nm [%] | 35.40 | 0.00 | 0.00 | 0.00 | 0.00 |
| | Transmittance at 1,032 nm [%] | 39.20 | 36.30 | 56.90 | 52.60 | 53.20 |
| <Debonding property by IR laser light (wavelength: 1,032 nm)> | Debondability | ○ | ○ | ○ | ○ | ○ |
| | Site to be debonded | Interface between photothermal conversion layer and glass | Interface between photothermal conversion layer and glass | Interface between photothermal conversion layer and glass | Interface between photothermal conversion layer and glass | Interface between photothermal conversion layer and glass |
| <Debonding property by UV laser light (wavelength: 355 nm)> | Debondability | ○ | ○ | ○ | ○ | ○ |
| | Site to be debonded | Interface between photothermal conversion layer and glass | Interface between photothermal conversion layer and glass | Interface between photothermal conversion layer and glass | Interface between photothermal conversion layer and glass | Interface between photothermal conversion layer and glass |
| <Chemical resistance of photothermal conversion layer> ~After UV irradiation (1,380 mJ/cm²)~ | Tensile modulus of elasticity E' of photothermal conversion layer [MPa] | 2,818.4 | 38.8 | 7.8 | 2 | 0.4 |
| | Nanoindenter modulus of elasticity Er of photothermal conversion layer [MPa] | 18,213 | 334.7 | 72.2 | 20.6 | 4.4 |
| | Appearance after being bonded to glass and immersed into NMP, and being left at 25°C for 15 min | ○ | ○ | ○ | × | × |
| <Heat resistance of photothermal conversion layer> | 5% weight loss temperature [°C] | 347.8 | 330.2 | 410.4 | 358.5 | 342.7 |

| Item | | Comparative Example 1 | Comparative Example 2 | Comparative Example 3 | Comparative Example 4 |
|---|---|---|---|---|---|
| Configuration | Pressure-sensitive adhesive layer | Pressure-sensitive adhesive A | Pressure-sensitive adhesive A | Pressure-sensitive adhesive A | Pressure-sensitive adhesive A |
| | Base material | Polyimide film | PET film | Black printed PET (1) | Black printed PET (2) |
| | Composition for forming photothermal conversion layer | Composition "i" for forming resin layer | Composition "i" for forming resin layer | Composition "i" for forming resin layer | Composition "i" for forming resin layer |
| | Thickness of adhesive/pressure-sensitive adhesive sheet [µm] | 45 | 58 | 45.2 | 48 |
| Pressure-sensitive adhesive characteristic of pressure-sensitive adhesive layer | Normal pressure-sensitive adhesive strength to PET #25 [N/20 mm] | 0.82 | 0.82 | 0.82 | 0.82 |
| Pressure-sensitive adhesive characteristic of photothermal conversion layer | Normal pressure-sensitive adhesive strength to glass [N/20 mm] | 5.83 | 5.12 | 6.12 | 6.05 |
| | Pressure-sensitive adhesive strength to glass after UV irradiation (1,380 mJ/cm²) [N/20 mm] | 0.08 | 0.06 | 0.09 | 0.1 |
| Optical characteristics | Transmittance at 355 nm [%] | 0.00 | 81.60 | 0.34 | 0.00 |
| | Transmittance at 1,032 nm [%] | 86.40 | 89.90 | 42.01 | 2.26 |
| <Debonding property by IR laser light (wavelength: 1,032 nm)> | Debondability | × | × | ○ | ○ |
| | Site to be debonded | - | - | Photothermal conversion layer (cohesive failure) | Photothermal conversion layer (cohesive failure) |
| <Debonding property by UV laser light (wavelength: 355 nm)> | Debondability | ○ | × | ○ | ○ |
| | Site to be debonded | Interface between base material layer and pressure-sensitive adhesive layer | - | Photothermal conversion layer (cohesive failure) | Photothermal conversion layer (cohesive failure) |
| <Chemical resistance of photothermal conversion layer> ~After UV irradiation (1,380 mJ/cm²)~ | Tensile modulus of elasticity E' of photothermal conversion layer [MPa] | 2,238.7 | 2,238.7 | - | - |
| | Nanoindenter modulus of elasticity Er of photothermal conversion layer [MPa] | 14, 674.7 | 14,674.7 | 25.7 | 23.9 |
| | Appearance after being bonded to glass and immersed into NMP, and being left at 25°C for 15 min | ○ | ○ | × | × |
| <Heat resistance of photothermal conversion layer> | 5% weight loss temperature [°C] | - | - | 298.9 | 240.6 |

### Reference Signs List

**10** photothermal conversion layer
**20** base material
**30** pressure-sensitive adhesive layer
**110, 110', 110''** adhesive/pressure-sensitive adhesive sheet for temporarily fixing electronic part

## Claims

1. An adhesive/pressure-sensitive adhesive sheet for temporarily fixing an electronic part, comprising a photothermal conversion layer,
wherein the adhesive/pressure-sensitive adhesive sheet for temporarily fixing an electronic part has a transmittance for light having a wavelength of 1,032 nm of 60% or less,
wherein the adhesive/pressure-sensitive adhesive sheet for temporarily fixing an electronic part has a transmittance for light having a wavelength of 355 nm of 60% or less,
wherein the photothermal conversion layer contains carbon black, and
wherein the photothermal conversion layer has a 5% weight loss temperature after UV irradiation of 300°C or more.

2. The adhesive/pressure-sensitive adhesive sheet for temporarily fixing an electronic part according to claim 1, wherein the photothermal conversion layer includes a curable resin composition.

3. The adhesive/pressure-sensitive adhesive sheet for temporarily fixing an electronic part according to claim 2, wherein the photothermal conversion layer contains a photopolymerization initiator.

4. The adhesive/pressure-sensitive adhesive sheet for temporarily fixing an electronic part according to claim 3, wherein the curable resin composition contains a pentaerythritol-based polyfunctional (meth)acrylate.

5. The adhesive/pressure-sensitive adhesive sheet for temporarily fixing an electronic part according to claim 1, wherein the photothermal conversion layer contains a styrene-based thermoplastic elastomer.

6. The adhesive/pressure-sensitive adhesive sheet for temporarily fixing an electronic part according to claim 1, further comprising a base material,
wherein the photothermal conversion layer is arranged on at least one side of the base material.
